# EUROPÄISCHE PATENTSCHRIFT

(11) **EP 1 015 931 B1**
(45) Veröffentlichungstag und Bekanntmachung des Hinweises auf die Patenterteilung: **29.03.2006**
(21) Anmeldenummer: 99929277.4
(22) Anmeldetag: 18.06.1999
(51) Int. Cl.: G02B 7/02, G02B 26/06, G03F 7/20

(54) **PROJEKTIONS-BELICHTUNGSANLAGE DER MIKROLITHOGRAPHIE**
PROJECTION LIGHT FACILITY FOR MICROLITHOGRAPHY
INSTALLATION D'ECLAIRAGE POUR PROJECTION SERVANT A LA MICROLITHOGRAPHIE

(30) Priorität: 20.06.1998 DE 19827603
(43) Veröffentlichungstag der Anmeldung: 05.07.2000
(73) Patentinhaber: Carl Zeiss SMT AG, 73446 Oberkochen (DE)
(72) Erfinder: GABER, Erwin, D-89522 Heidenheim (DE); WAGNER, Christian, D-73431 Aalen (DE); HOLDERER, Hubert, D-89551 Königsbronn (DE); GERHARD, Michael, D-73432 Aalen (DE); MERZ, Erich, D-73457 Essingen (DE); BECKER, Jochen, D-73447 Oberkochen (DE); SCHEIBERLICH, Arie, Cormelis, NL-5503 HG Veldhoven (NL)
(74) Vertreter: Ostertag, Ulrich
(86) Internationale Anmeldenummer: PCT/EP1999/004246
(87) Internationale Veröffentlichungsnummer: WO 1999/067683

(56) Entgegenhaltungen:
- EP-A- 0 678 768
- WO-A-96/13741
- DE-A- 3 404 063
- US-A- 4 155 631
- US-A- 4 226 507
- US-A- 4 492 431
- US-A- 4 993 823
- PATENT ABSTRACTS OF JAPAN vol. 199, no. 806, 30. April 1998 (1998-04-30) & JP 10 039208 A (NIKON CORP), 13. Februar 1998 (1998-02-13)
- PATENT ABSTRACTS OF JAPAN vol. 199, no. 905, 31. Mai 1999 (1999-05-31) & JP 11 044834 A (CANON INC), 16. Februar 1999 (1999-02-16)

## Beschreibung

Die Erfindung betrifft eine Projektions-Belichtungsanlage gemäß dem Oberbegriff des Anspruchs 1.

Eine solche Projektions-Belichtungsanlage ist in der EP 0 678 768 A2 beschrieben. Dabei werden Step- und Scan-Prozesse eingesetzt, bei denen von einer Maske nur ein schmaler, schlitzförmiger Streifen auf einen Wafer übertragen wird. Um das gesamte Feld zu belichten, werden dabei ein Reticle und der Wafer seitlich verschoben (Scanning).

Nachteilig dabei ist jedoch, daß durch diese Schlitzgeometrie vor allem auf den wafernahen Linsen ein rotationsunsymmetrischer Beleuchtungsabdruck entsteht. Dies bedeutet, daß die durch die zwangsläufige Linsenerwärmung entstehende Temperaturverteilung auf der Linse ebenfalls rotationsunsymmetrisch ist und deshalb über den linearen Zusammenhang Brechzahl-Temperatur und thermische Ausdehnung zu Bildfehlern, wie z.B. Astigmatismus, auf der optischen Achse führt.

In der 193nm-Lithographie führt die Durchsetzung der Quarzglas-Linsen mit dem 193nm-Licht zu einer Volumenabnahme des Quarzglases, die monoton wachsend mit NI² geht. Hierbei ist N die Anzahl der Laserpulse und I die Pulsdosis. Des weiteren kommt es zu einer Brechzahlerhöhung. Da die Brechzahlzunahme die Abnahme der optischen Weglänge durch die Schrumpfung überkompensiert, ist die Folge dieses Compaction genannten Effekts eine Störung der Wellenfront. Diese führt ebenso wie eine Linsenerwärmung (Lens-Heating) zu Bildfehlern wie Astigmatismus auf der optischen Achse.

Im Gegensatz zu einer Kompensation der Linsenerwärmung gibt es für den Compaction-Effekt keine passive Kompensation. Hier müßte aktiv durch Verändern eines Linsenelements die Änderung der Wellenfront kompensiert werden. Da es in einem refraktiven Design nicht die Möglichkeit gibt, einen aktiven Spiegel einzusetzen (der Aufwand, einen zusätzlichen Spiegel zur Bildfehler-Kompensation einzuführen, scheidet im allgemeinen aus), müssen eine oder mehrere Linsen als "Stellglieder" verwendet werden. Um Astigmatismus auf der Achse zu korrigieren, scheiden Bewegungen entlang der optischen Achse sowie Dezentrierungen aus. Hiermit fallen alle translatorischen Freiheitsgrade als Möglichkeit zu einer Korrektur aus.

In der EP 0 678 768 A2 ist nun vorgeschlagen worden, eine Linse als "Stellglied" zu verwenden, um den durch eine ungleichmäßige Erwärmung der Linse erzeugten Bildfehler zu korrigieren. Hierzu ist gemäß Figur 11 vorgesehen, in radialer Richtung wirkende Kräfte auf die Linse einwirken zu lassen. Durch die auf diese Weise erzeugten Druckkräfte wird jedoch nur eine asymmetrische Dickenänderung erzeugt.

In der EP 0 660 169 A1 ist eine Projektions-Belichtungsanlage der Mikrolithographie beschrieben, bei der die Objektive mit Korrekturelementen versehen sind. Hierzu ist unter anderem ein Linsenpaar vorgesehen, das um die optische Achse drehbar ist. Dabei wird die Brechkraft durch die Form der Linse durch Überlagern einer zylindrischen Meniskus-Form über eine sphärische Linse geändert.

Aus der US 4 993 823 A ist ein Verfahren zur Korrektur thermischer Verformungen von optischen Elementen bekannt, die für eine Verwendung in Teleskopen vorgesehen sind. Bei einem dort beschriebenen Ausführungsbeispiel greifen mehrere Kraftaktuatoren unmittelbar an einer Linse an, um diese zu verbiegen.

Der vorliegenden Erfindung liegt die Aufgabe zugrunde, eine Projektions-Belichtungsanlage der eingangs erwähnten Art zu schaffen, bei welchem die durch die ungleichmäßige Temperaturverteilung in der Anlage zwangsläufig auftretenden Bildfehler mit einfachen Mitteln korrigiert bzw. minimiert werden können.

Erfindungsgemäß wird diese Aufgabe durch eine Projektions-Belichtungsanlage mit den Merkmalen des Anspruchs 1 gelöst.

Im Unterschied zum Stande der Technik werden nicht lediglich Druckkräfte erzeugt, die lediglich eine asymmetrische Dickenänderung ergeben, sondern durch die erzeugten Schubkräfte bzw. Torsion wird eine Durchbiegung des optischen Elementes, wie z.B. einer Linse, erzielt, die dabei so gewählt wird, daß die zwangsläufig auftretenden Bildfehler weitestgehend kompensiert werden. Mit den erfindungsgemäßen Aktuatoren kann eine Linse gezielt um einige 100nm bis *µ*m, deformiert werden. Auf diese Weise läßt sich beispielsweise eine Kompensation von Astigmatismus r² und r⁴ erreichen.

Erfindungsgemäß lassen sich die gewünschten Temperaturverteilungen mit einfachen Maßnahmen rasch und zuverlässig erreichen. Dies ist insbesondere dann der Fall, wenn nur bestimmte Bildfehler, z.B. Bildfehler niederer Ordnung, korrigiert werden sollen.

Ein weiterer sehr bedeutender Vorteil der Erfindung besteht darin, daß im Bedarfsfall auch "Überkompensierungen" und die zusätzliche Kompensation von Fertigungsfehlern möglich ist. Anstelle von einer Symmetrisierung von mehreren einzelnen Linsen, wie es beim Stand der Technik der Fall ist, kann man auch einzelne Linsen "überkompensieren", d.h., die Temperaturverteilung bzw. Deformation bewußt "in eine andere Richtung" unsymmetrisch machen. Auf diese Weise ergibt sich dann insgesamt gesehen eine Kompensierung des ganzen Objektives oder der Belichtungsanlage.

Bezüglich einer Kompensation von Fertigungsfehlern gibt es zwei Varianten, nämlich eine gleichzeitige Kompensation zufälliger Fertigungsfehler und ein absichtlicher Einbau eines festen Vorhalts, um die benötigten Korrekturbeträge zu halbieren.

Erfindungsgemäß ist auch eine gleichzeitige Kompensation von Lens Heating- und von Compaction-Effekten des optischen Elementes möglich.

Die erfindungsgemäße Projektions-Belichtungsanlage läßt sich mit besonderem Vorteil in der Halbleiterlithographie einsetzen, da bei der zunehmenden Verkleinerung der abzubildenden Strukturen auftretende Bildfehler ebenfalls minimiert werden müssen.

Mit den erfindungsgemäßen Aktuatoren läßt sich gezielt ein Astigmatismus zur Kompensation des thermischen Astigmatismus und aufgrund von Compaction-Effekten in der Linse erzeugen.

Von Vorteil ist es auch, daß es - in Abhängigkeit von der Anordnung und Anzahl der Aktuatoren - darüber hinaus möglich ist, andere Deformationen der Linse zu erzeugen.

Vorteilhafte Ausgestaltungen der Erfindung ergeben sich aus den Unteransprüchen und aus den nachfolgend anhand der Zeichnung prinzipmäßig beschriebenen Ausführungsbeispielen.

Es zeigen:
- Figur 1: eine schematische Draufsicht auf ein optisches Element mit erfindungsgemäßen Aktuatoren;
- Figur 2: einen Schnitt nach der Linie II-II der Figur 1;
- Figur 3: ein zweites Ausführungsbeispiel für ein optisches Element mit erfindungsgemäßen Aktuatoren;
- Figur 4: einen Schnitt nach der Linie IV-IV der Figur 3;
- Figur 5: ein drittes Ausführungsbeispiel für ein optisches Element mit erfindungsgemäßen Aktuatoren;
- Figur 6: einen Schnitt nach der Linie VI-VI der Figur 5;
- Figur 7: einen Schnitt, ähnlich den Schnitten in den Figuren 2, 4 und 6 durch ein viertes Ausführungsbeispiel für ein optisches Element mit Piezos als Aktuatoren, das nicht Gegenstand der Erfindung ist;
- Figur 8: einen Halbschnitt durch ein fünftes Ausführungsbeispiel für ein optisches Element mit erfindungsgemäßen Aktuatoren;
- Figur 9: eine Teil-Draufsicht auf eine einstückige Aus- gestaltung von Fassungsring und mit diesem bundenen Rahmen als Alternative zu der in Figur 8 gezeigten zweiteiligen Ausgestaltung.

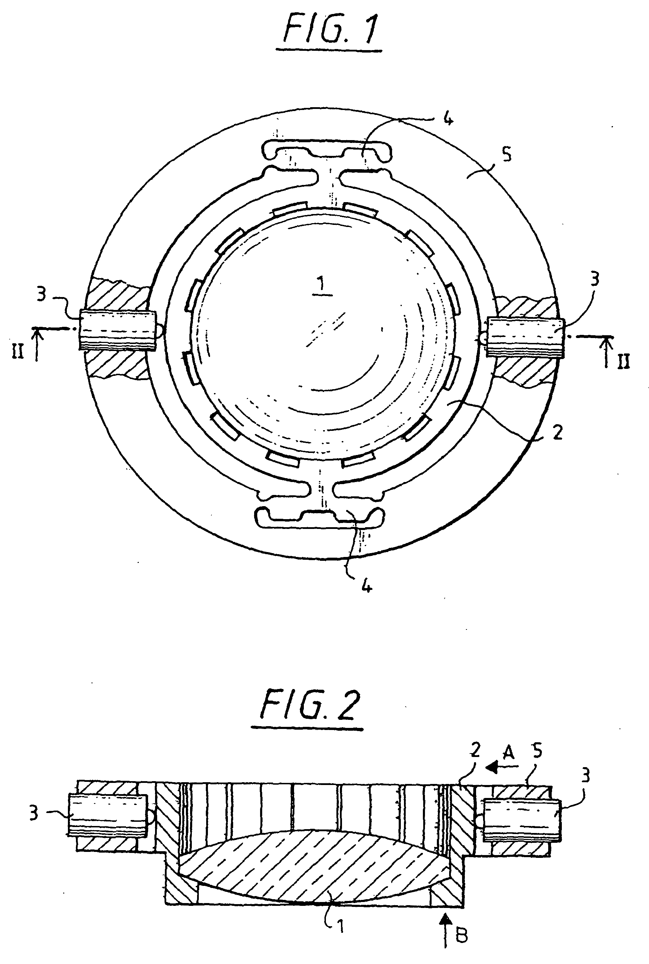

Da eine Projektions-Belichtungsanlage in der Mikrolithographie allgemein bekannt ist, wird nachfolgend nur ein optisches Element daraus, nämlich eine Linse 1 beschrieben, die in einem deformierbaren Fassungsring 2 als Fassung gehalten ist. Aktuatoren 3 in Form von Stellschrauben sind in einem den Fassungsring 2 umgebenden Rahmen 5 angeordnet. Zwei sich gegenüberliegende Gelenke 4 stellen die Verbindung zwischen dem Fassungsring 2 und dem Rahmen 5 her. Zur Stabilisierung entlang der optischen Achse können gegebenenfalls weitere Gelenke 4 mit hoher Steifigkeit entlang der optischen Achse angeordnet werden. Wie aus dem Ausführungsbeispiel nach den Figuren 1 und 2 ersichtlich ist, liegen sich zwei Aktuatoren 3 diametral gegenüber.

Wie aus der Figur 2 ersichtlich, weist der Fassungsring 2 eine Topfform mit offenem Boden auf, wobei die beiden Aktuatoren 3 am oberen Rand angeordnet sind und eine Radialkraft erzeugen. Die Linse 1 liegt an einem keilförmigen unteren Bodenrand des Fassungsringes 2 an, wodurch beim Aufbringen von Kräften durch die Aktuatoren 3 in Pfeilrichtung A gemäß Figur 2 Biegemomente in Pfeilrichtung B parallel zur optischen Achse auf die Linse 1 erzeugt werden. Die als Stellschrauben ausgebildeten Aktuatoren 3 können hydraulisch oder im Bedarfsfall auch auf andere Weise aktiviert werden. Wie ersichtlich, leiten sie gezielt ein Moment in den Fassungsring 2 ein, der zu einer Deformation im Sinne einer Durchbiegung der Linse 1 führt.

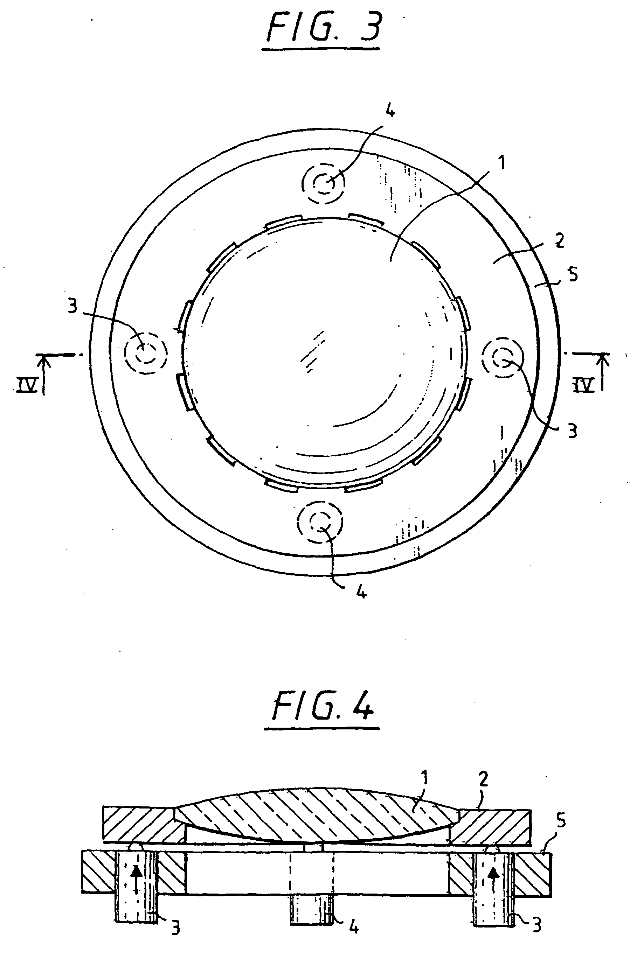

Die Figuren 3 und 4 zeigen einen Rahmen 5, wobei ebenfalls wie beim Ausführungsbeispiel nach den Figuren 1 und 2 ein Moment in einen deformierbaren Fassungsring 2 eingeleitet wird. Wie insbesondere aus der Figur 4 ersichtlich ist, liegen dabei der Rahmen 5 und der Fassungsring 2 teilweise parallel zur optischen Achse hintereinander, weshalb in diesem Falle auch die beiden sich gegenüberliegenden Aktuatoren 3 mit ihren Längsachsen parallel zur optischen Achse liegen und auf diese Weise ebenfalls parallel zur optischen Achse gerichtete Kräfte erzeugen können.

Um jeweils 90° versetzt zu den Aktuatoren 3 sind nicht näher dargestellte Fixierungs- bzw. Klemmstellen 4 zur Verbindung des Rahmens 5 mit dem Fassungsring 2 vorgesehen. Im Unterschied zu dem Ausführungsbeispiel nach den Figuren 1 und 2 wird dabei der Fassungsring 2 an zwei gegenüberliegenden Stellen am Rahmen 5 festgehalten und an den um 90° gedreht liegenden Stellen entlang der optischen Achse verbogen.

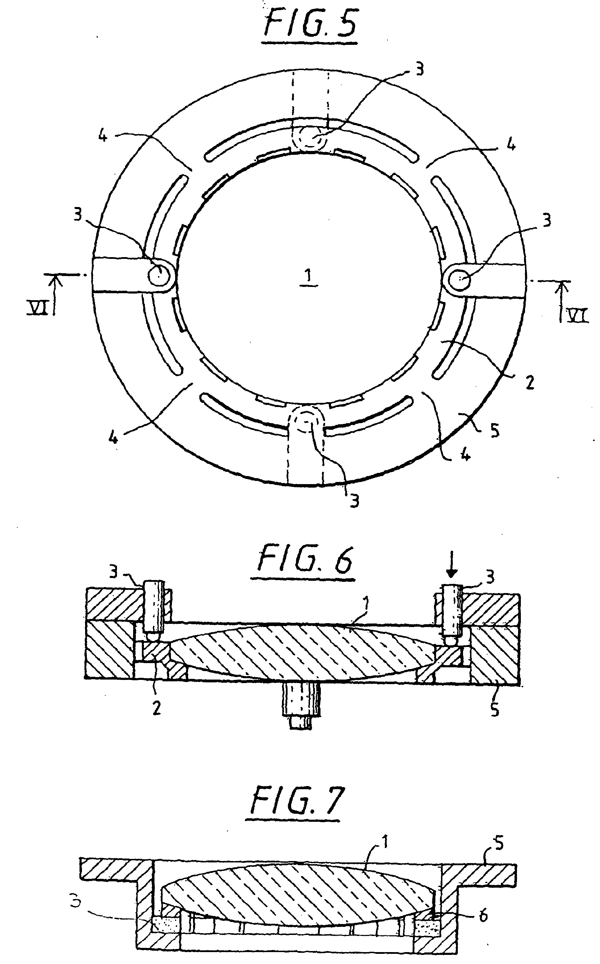

Das in den Figuren 5 und 6 dargestellte Ausführungsbeispiel führt zu keiner Verschiebung entlang der optischen Achse, da hier gleichzeitig an zwei gegenüberliegenden Stellen nach unten und jeweils um 90° versetzt dazu nach oben durch die entsprechend angeordneten Aktuatoren 3 gedrückt wird. Wie ersichtlich, erzeugen dabei wie beim Ausführungsbeispiel nach den Figuren 3 und 4 z.B. horizontal sich gegenüberliegende Aktuatoren nach unten gerichtete Biegemomente, während die vertikal sich gegenüberliegenden Aktuatoren 3 nach oben gerichtete Biegemomente an der Linse 1 erzeugen. Die Verbindung zwischen Fassungsring 2 und Rahmen 5 erfolgt durch vier gelenkartige Fixierungsstellen 4, die symmetrisch am Umfang verteilt jeweils zwischen Aktuatoren 3 angeordnet sind.

Die Figur 7 zeigt im Schnitt prinzipmäßig Aktuatoren 3, die als Piezos ausgebildet sind. Dabei kann man eine größere Anzahl von Aktuatoren bzw. Piezos 3, z.B. zwanzig Stück, auf einem Ringabsatz des Rahmens 5 bzw. der Fassung 2 derart verteilen, daß sie bei deren piezoelektrischen Aktivierung entsprechend ihrer Verteilung über den Umfang bestimmte Formen von Biegemomenten auf die Linse 1 ausüben. Zur Momenteinleitung befindet sich hierzu eine keilförmige Linsenauflage 6 als Zwischenglied zwischen den Piezos 3 und der Linse 1. Durch die größere Anzahl der Piezos als Aktuatoren 3 und deren beliebige Verteilung über den Umfang lassen sich beliebige Richtungen des Astigmatismus, 3-Welligkeiten und andere Effekte, wie z.B. Zylinderlinseneffekt, herstellen und gegebenenfalls überlagern. Das in der Figur 7 gezeigte Ausführungsbeispiel ist nicht Gegenstand der Erfindung, sondern dient als Beispiel für die Ausbildung der Aktuatoren als Piezo.

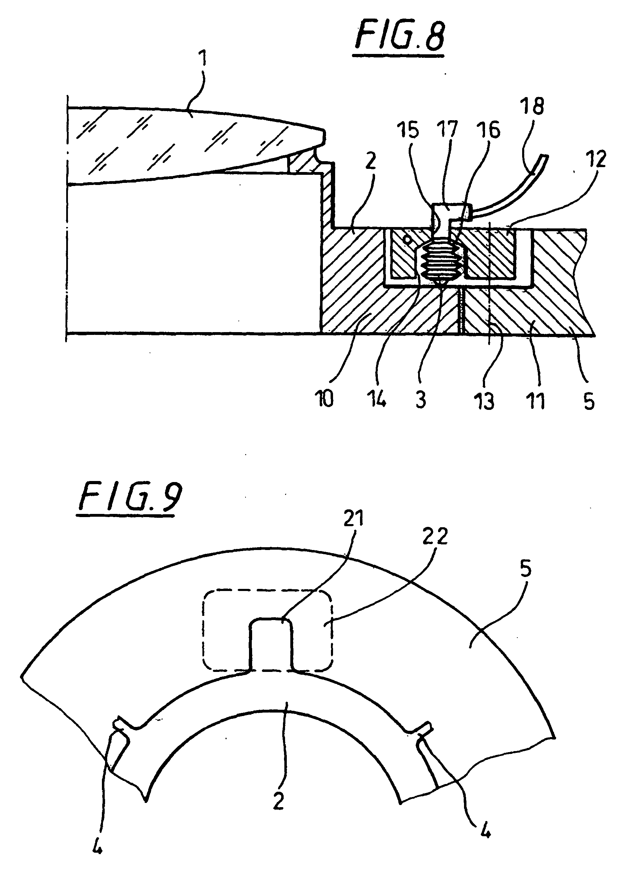

Figur 8 zeigt einen Teilschnitt durch ein weiteres Ausführungsbeispiel. Zu erkennen sind wiederum die Linse 1, die in einem deformierbaren Fassungsring 2 gehalten ist, sowie der den Fassungsring 2 umgebende Rahmen 5. Der Fassungsring 2 weist an seinem äußeren Umfang einen Randflansch 10 geringerer Dicke auf; der Rahmen 5 ist an seinem Innenumfang mit einem Randflansch 11 derselben Dicke versehen, derart, daß zwischen dem Fassungsring 2 und dem Rahmen 5 eine ringförmige nutartige Vertiefung entsteht.

In dieser nutartigen Vertiefung ist ein ringförmiger Aktuatorenhalter 12 eingesetzt und mit dem Randflansch 11 des Rahmens 5 verschraubt, wie dies durch das Bezugszeichen 13 angedeutet ist. Der Aktuatorenhalter 11 ist an mehreren Stellen über den Umfang verteilt, z.B. an zwei diametral gegenüberliegenden Stellen, mit zylindrischen Aufnahmeöffnungen 14 versehen, die über eine Durchgangsbohrung 15 kleineren Durchmessers mit der Oberseite des Aktuatorenhalters 11 in Verbindung steht. Auf diese Weise entsteht zwischen der Aufnahmeöffnung 14 und der Durchgangsbohrung 15 eine ringförmige Schulter 16.

In jeder Aufnahmeöffnung 14 befindet sich ein pneumatischer Balg 3, der in diesem Ausführungsbeispiel als Aktuator dient. Die Unterseite dieses Balges 3 liegt an dem ringförmigen Flansch 10 des deformierbaren Fassungsringes 2 an; eine ringförmige obere Stirnfläche des Balges 3 liegt an der Stufe 16 zwischen Aufnahmeöffnung 14 und Durchgangsbohrung 15 des Aktuatorenhalters 11 an. Ein winkelförmiger Anschluß 17 für den Balg 3 ist durch die Durchgangsöffnung 15 hindurchgeführt und steht mit einem Schlauch 18 in Verbindung, über den unter Druck stehendes Gas zugeführt wird.

Die Druckregelung des Gases kann auf unterschiedliche Weise erfolgen:

Im einfachsten Fall ist direkt am Regelventil (nicht dargestellt) und/oder an dem Fassungsring 2 ein einfacher Gasdrucksensor angebracht, der eine Rückmeldung über den tatsächlich erreichten Gasdruck im Balg 3 an die Steuerung gibt. Alternativ kann am Fassungsring 2 ein Wegsensor (nicht dargestellt) angebracht werden, der die tatsächliche Verbiegung des Fassungsringes 2 feststellt und entsprechend an die Steuerung meldet. Dieser Wegsensor kann beispielsweise kapazitiv arbeiten.

Sowohl die Gasdruckregelung über den Gasdrucksensor als auch die Wegmessung über den Wegsensor können durch mehrfaches Vorsehen des Sensors in ihrer Genauigkeit gesteigert werden. Beispielsweise können vier Gasdrucksensoren vorhanden sein, deren Signal in der Steuerung mit vier geeichten Gasdruckkurven, die dort abgespeichert sind und den jeweiligen Gasdruck zu der erzeugten Deformation in Beziehung setzen, korreliert wird. Entsprechend lassen sich auch vier Wegsensoren am Fassungsring 2 anordnen.

Die Verbindung zwischen dem Fassungsring 2 und dem Rahmen 5 erfolgt wiederum über gelenkartige Einrichtungen, die in den Winkelbereichen zwischen den Bälgen 3 vorgesehen sind.

Die Verbindung zwischen Fassungsring 2 und Rahmen 5 ist besonders elegant in der Ausführungsform nach Figur 9 verwirklicht. Fassungsring 2 und Rahmen 5 sind hier aus einem einheitlichen Werkstück hergestellt, das in der dargestellten Form durch Schlitze 20 funktional in die beiden Komponenten 2 und 5 unterteilt ist. Die Schlitze 20 können besipielswiese durch Elektroerosion eingebracht sein. Sie folgen weitgehend einem Kreis, dessen Mittelpunkt auf der Achse des optischen Systems liegt, und biegen an ihren benachbarten Enden geringfügig radial nach außen ab. So entstehen zwischen Fassungsring 2 und Rahmen 5 als verformbare Gelenke dienende Materialbrücken 4. Gegen die Materialbrücken 4 um 90° versetzt sind die Schlitze 20 mit radial vorspringenden Zungen 21 ausgebildet. Auf diese wirkt jeweils von der hinter der Zeichenebene liegenden Seite her ein Balg, wie er in Figur 8 dargestellt ist. Dieser Balg ist mit einem eigenen, diesmal nicht ringförmigen Aktuatorenträger in einer Tasche 22 (gestrichelt angedeutet) untergebracht, die in die hinter der Zeichenebene liegende Stirnfläche von Fassungsring 2 und Rahmen 5 eingearbeitet ist.

Die Verwendung pneumatisch betätigter Bälge 3 als Aktuatoren hat gegenüber den Ausführungsbeispielen, die weiter oben beschrieben worden sind, den Vorteil eines einfachen mechanischen Prinzips, das keine Führungen benötigt und daher weitgehend reibungs- und verschleißfrei ist, sowie den Vorteil einer hohen Verstellgeschwindigkeit.

Mit den vorstehend beschriebenen Aktuatoren ist es möglich, Linsen 1 zu einer Fassung so zu deformieren, daß Abbildungsfehler von Oberflächenfehlern anderer Linsen kompensiert werden können. Dies bedeutet, es wird an einer oder an einigen Linsen 1 eine "Überkompensation" durchgeführt. Damit wird die Abbildungsqualität des gesamten Objektivs verbessert. Außerdem können Änderungen der Brechung durch Compaction bei Quarz oder durch Erwärmung der Linse im Betrieb so kompensiert werden, daß die optische Qualität über die gesamte Lebensdauer des Objektivs gewährleistet wird.

Im allgemeinen wird man eine Linse 1 im oberen Drittel des Objektives für eine Deformation verwenden, bei der das Verhältnis von Büscheldurchmesser des Lichtbündels zu Linsendurchmesser das richtige Verhältnis von Verzeichnungs- zu Astigmatismuswirkung liefert. Außerdem ist der Feldverlauf über den Büscheldurchmesser zu manipulieren. Für eine Linse im Blendenraum ergibt sich ein Astigmatismus, der über das Bildfeld konstant ist, und keine Verzeichnungswirkung. Für eine Linse sehr nahe am Reticle ergibt sich ein Verzeichnungsanamorphismus, aber nur eine sehr geringe Astigmatismuswirkung.

Die Aktuatoren, insbesondere die Piezos sowie die pneumatischen Bälge, können mit einem Getriebe, z.B. Linear- oder Hebelgetriebe, für Unter- oder Übersetzungen versehen werden. Hierzu kann man in vorteilhafter Weise Festkörpergelenke einsetzen.

## Patentansprüche

1. Projektions-Belichtungsanlage der Mikrolithographie mit einem schlitzförmigen Bildfeld oder einer nicht rotationssymmetrischen Beleuchtung, mit einer Linse (1) und mit Aktuatoren (3),
**dadurch gekennzeichnet, daß**
- die Linse (1) in einer die Linse (1) haltenden deformierbaren Fassung (2) angeordnet ist, und daß
- die Aktuatoren (3)
-- derart angeordnet sind, daß sie an der Linse nicht rotationssymmetrische und von der Radialen abweichende Kräfte und/oder Momente erzeugen, um im wesentlichen ohne Dickenänderungen sich ergebende Verbiegungen zu bewirken, und
-- derart an der deformierbaren Fassung (2) angreifen, daß die Fassung (2) Schubkräfte und/oder Biegemomente an der Linse (1) erzeugt.

2. Projektions-Belichtungsanlage nach Anspruch 1, **dadurch gekennzeichnet, daß** wenigstens zwei Aktuatoren (3) sich gegenüberliegend vorgesehen sind.

3. Projektions-Belichtungsanlage nach Anspruch 1 oder 2, **dadurch gekennzeichnet, daß** die Aktuatoren hydraulisch, mechanisch oder elektrisch betätigte Stellglieder aufweisen.

4. Projektions-Belichtungsanlage nach einem der vorhergehenden Ansprüche, **dadurch gekennzeichnet, daß** zwei sich gegenüberliegende Aktuatoren (3) parallel zur optischen Achse verlaufende Schubkräfte und/oder Momente und zwei jeweils um 90° dazu versetzte Aktuatoren (3) entgegengesetzt zu diesen Schubkräften und/oder Momenten gerichtete Schubkräfte und/oder Momente erzeugen.

5. Projektions-Belichtungsanlage nach einem der vorhergehenden Ansprüche, **dadurch gekennzeichnet, daß** die Aktuatoren Getriebe aufweisen.

6. Projektions-Belichtungsanlage nach Anspruch 5, **dadurch gekennzeichnet, daß** die Getriebe Festkörpergelenke aufweisen.

7. Projektions-Belichtungsanlage nach einem der vorhergehenden Ansprüche, **dadurch gekennzeichnet, daß** die Aktuatoren (3) mit pneumatischen Bälgen versehen sind, die an der deformierbaren Fassung (2) angreifen.

## Claims

1. Projection exposure apparatus for microlithography
with a slit-shaped image field or a non-rotationally symmetrical illumination, comprising a lens (1) and actuators (3),
**characterized in that**
- the lens (1) is received in a deformable mount (2) holding the lens (1), and **in that**
- the actuators (3)
- are arranged such that they produce at the lens non-rotationally symmetrical forces deviating from the radial and/or moments for effecting bendings which result substantially without thickness changes, and
- engage on the deformable mount (2) such that the mount (2) produces thrust forces and/or bending moments on the lens (1).

2. Projection exposure apparatus according to claim 1, **characterized in that** at least two mutually opposite actuators (3) are provided.

3. Projection exposure apparatus according to claim 1 or 2, **characterized in that** the actuators comprise hydraulically, mechanically or electrically actuated adjusting members.

4. Projection exposure apparatus according to any of the proceeding claims, **characterized in that** two mutually opposite actuators (3) produce thrust forces and/or moments running parallel to the optical axis, and two actuators (3), respectively displaced at 90° thereto, produce thrust forces and/or moments that are directed opposed to these thrust forces and/or moments.

5. Projection exposure apparatus according to any of the proceeding claims, **characterized in that** the actuators comprise transmissions.

6. Projection exposure apparatus according to claim 5, **characterized in that** the transmissions comprise solid state joints.

7. Projection exposure apparatus according to any of the proceeding claims, **characterized in that** the actuators (3) are provided with pneumatic bellows, which engage the deformable mount (2).

## Revendications

1. Système d'exposition par projection pour la microlithographie avec un champ d'image en forme de fente ou un éclairage sans symétrie de révolution, avec une lentille (1) et avec des actionneurs (3),
**caractérisé par le fait que**
- la lentille (1) est disposée dans une monture déformable (2) retenant la lentille (1), et que
- les actionneurs (3)
-- sont disposés de telle manière qu'ils génèrent sur la lentille des forces et/ou des couples sans symétrie de révolution et différant de la radiale pour provoquer des déformations essentiellement sans modifications d'épaisseur et
-- agissent sur la monture déformable (2) de telle manière que la monture (2) génère des forces de cisaillement et/ou des couples de flexion sur la lentille (1).

2. Système d'exposition par projection selon la revendication 1, **caractérisé par le fait qu'**il est prévu au moins deux actionneurs (3) situés en face l'un de l'autre.

3. Système d'exposition par projection selon la revendication 1 ou 2, **caractérisé par le fait que** les actionneurs présentent des organes de réglage à commande hydraulique, mécanique ou électrique.

4. Système d'exposition par projection selon l'une des revendications précédentes, **caractérisé par le fait que** deux actionneurs (3) situés en face l'un de l'autre génèrent des forces de cisaillement et/ou des couples parallèles à l'axe optique et deux actionneurs (3) décalés de 90° par rapport à chacun d'eux génèrent des forces de cisaillement et/ou des couples opposés à ces forces de cisaillement et/ou couples.

5. Système d'exposition par projection selon l'une des revendications précédentes, **caractérisé par le fait que** les actionneurs présentent des mécanismes de transmission.

6. Système d'exposition par projection selon la revendication 5, **caractérisé par le fait que** les mécanismes de transmission présentent des articulations solides.

7. Système d'exposition par projection selon l'une des revendications précédentes, **caractérisé par le fait que** les actionneurs (3) sont munis de soufflets pneumatiques qui agissent sur la monture déformable (2).
